## Europäisches Patentamt
## European Patent Office
## Office européen des brevets

(19)

(11) Numéro de publication: **0 056 921**
**A2**

(12)

# DEMANDE DE BREVET EUROPEEN

(21) Numéro de dépôt: **81402054.1**

(22) Date de dépôt: **22.12.81**

(51) Int. Cl.³: **H 03 K 4/83**
**H 03 K 4/72**

(30) Priorité: **23.01.81 FR 8101296**

(43) Date de publication de la demande:
**04.08.82 Bulletin 82/31**

(84) Etats contractants désignés:
**DE GB IT NL SE**

(71) Demandeur: **THOMSON-BRANDT**
**173, Boulevard Haussmann**
**F-75360 Paris Cedex 08(FR)**

(72) Inventeur: **Guillon, Jean-Claude**
**THOMSON-CSF SCPI 173, bld Haussmann**
**F-75360 Paris Cedex 08(FR)**

(72) Inventeur: **Potin, Michel**
**THOMSON-CSF SCPI 173, bld Haussmann**
**F-75360 Paris Cedex 08(FR)**

(74) Mandataire: **Grynwald, Albert et al,**
**THOMSON-CSF SCPI 173, Bld Haussmann**
**F-75360 Paris Cedex 08(FR)**

(54) Dispositif de balayage vertical à boucle d'asservissement en tension et récepteur de télévision comportant un tel dispositif.

(57) Dispositif de balayage vertical pour récepteur de télévision dans lequel l'énergie nécessaire pour engendrer le courant traversant le déviateur vertical (9) est tirée des impulsions de retour ligne grâce à un moyen de filtrage (4, 8) en série avec un interrupteur commandé (5, 6, 7) qui, à chaque ligne, est conducteur pendant un temps qui est fonction du numéro de cette ligne, le déviateur vertical (9) étant en série avec un condensateur de liaison (10) dont la tension moyenne à ses bornes est maintenue sensiblement constante grâce à une boucle (30) de régulation statique.

La tension aux bornes du condensateur de liaison (10) est introduite dans la boucle statique par l'intermédiaire d'un échantillonneur-bloqueur (34, 40) qui, à chaque période de retour de balayage vertical, emmagasine un signal représentant une tension et maintient celle-ci pratiquement constante pendant la période de balayage vertical et qui est précédé par un réseau correcteur (41, 41a) permettant d'augmenter le gain en boucle ouverte de la boucle statique.

EP 0 056 921 A2

./...

FIG_1

# DISPOSITIF DE BALAYAGE VERTICAL A BOUCLE D'ASSERVISSEMENT EN TENSION ET RECEPTEUR DE TELEVISION COMPORTANT UN TEL DISPOSITIF.

L'invention est relative à un dispositif de balayage vertical et à un récepteur de télévision comportant un tel dispositif.

Elle vise plus particulièrement un dispositif de balayage vertical en commutation du type de celui décrit dans le brevet européen n° 79 400 520 au nom de la demanderesse.

On rappelle qu'en télévision les images sont obtenues par déplacement d'un point lumineux sur un écran selon des lignes horizontales de gauche à droite et de haut en bas. L'intensité du point lumineux dépend à chaque instant de l'intensité lumineuse du point correspondant de l'image à reproduire. Ce point lumineux est produit par l'impact d'un pinceau d'électrons, engendré par un canon à électrons, contre l'écran enduit de substances luminophores. Le déplacement du pinceau lumineux, pour déplacer le point sur l'écran, est obtenu à l'aide de deux champs magnétiques variant, en fonction du temps, selon une loi sensiblement en dents de scie. Ces champs magnétiques sont engendrés par deux bobines parcourues par des courants électriques dont l'intensité varie également sensiblement en dents de scie. L'une de ces bobines est appelée le déviateur horizontal ou "déviateur ligne" ; elle est parcourue par un courant variant sensiblement en dents de scie à la fréquence de balayage des lignes. L'autre bobine est appelée déviateur vertical ou "déviateur trame" ; elle est parcourue par un courant variant sensiblement en dents de scie à la fréquence de balayage vertical ou fréquence trame.

Le dispositif de balayage vertical décrit dans ledit brevet européen n° 79 400 520 comporte un circuit de puissance pour engendrer le courant parcourant le déviateur vertical qui tire son énergie des impulsions de retour des lignes ou "retour-ligne" c'est-à-dire de la surtension résultant de la variation brusque du courant dans le déviateur horizontal qui apparaît quand on passe d'une ligne à la suivante. Ces impulsions de retour-ligne sont recueillies aux bornes d'un enroulement secondaire d'un "transformateur-ligne" et sont filtrées pour alimenter le déviateur vertical. La variation désirée du courant dans ce déviateur est obtenue en agissant, à chaque ligne, sur le temps de conduction d'un interrupteur en série avec l'enroulement secondaire, l'interrupteur étant, à chaque ligne, conducteur pendant un temps qui est fonction du numéro de cette ligne.

Dans ce dispositif le déviateur vertical est en série avec un condensateur de liaison et une résistance de mesure. La capacité du condensateur est suffisamment élevée pour que la tension aux bornes de l'ensemble constitué par le déviateur, ce condensateur et la résistance de mesure garde un signe constant.

Pour commander l'interrupteur en série avec le secondaire du transformateur ligne on prévoit un générateur de signaux en dents de scie à la fréquence trame-auquel sont éventuellement superposés des signaux de correction, telle qu'une correction en S ou de linéarité - qui sont transmis à l'électrode de commande de l'interrupteur par l'intermédiaire d'un convertisseur tension-temps.

On compense des variations éventuelles de la tension d'alimentation du récepteur de télévision et/ou les variations des caractéristiques de composants du circuit à l'aide d'une boucle de régulation du courant appelée "boucle dynamique" et une boucle de régulation de la tension appelée "boucle statique".

Le signal de mesure de la boucle de régulation dynamique est la tension aux bornes de la résistance de mesure en série avec le déviateur vertical car cette tension est proportionnelle à l'intensité du courant traversant le déviateur.

La boucle de régulation statique permet de maintenir constante la valeur moyenne de la tension aux bornes du condensateur de liaison en série avec le déviateur vertical. On fixe ainsi le potentiel de l'une des bornes du déviateur vertical.

Dans la boucle statique du dispositif dudit brevet européen n° 79 400 520 le signal de mesure est la tension moyenne aux bornes du condensateur de liaison. A cet effet la tension aux bornes de ce condensateur est transmise par l'intermédiaire d'un filtre passe-bas à l'entrée d'un amplificateur qui reçoit les autres signaux de mesure et les signaux de consigne. La tension aux bornes de ce condensateur étant la primitive (fonction réciproque de la fonction dérivée) de l'intensité du courant qui le traverse, la variation de cette tension en fonction du temps a une allure parabolique car l'intensité du courant varie de façon linéaire. Cette variation parabolique n'est que partiellement éliminée par le filtre passe-bas. Elle affecte donc de façon défavorable les performances de la boucle de régulation. C'est pourquoi on a prévu jusqu'à présent de superposer une tension de correction de linéarité à la tension de consigne en dents de scie et de conférer une faible valeur au gain en boucle ouverte de l'asservissement statique. La première de ces dispositions complique la réalisation des circuits de commande du balayage. La seconde disposition ne permet pas d'obtenir une stabilité de la tension moyenne aux bornes du condensateur de liaison qui soit toujours satisfaisante.

L'invention permet d'améliorer dans de grandes proportions la qualité de la régulation statique et simplifie la réalisation des circuits.

Le dispositif de balayage vertical selon l'invention est caractérisé en ce que la tension aux bornes du condensateur de liaison est transmise à l'entrée d'un amplificateur par l'intermédiaire, d'une part, d'un circuit, ou réseau, correcteur à retard de phase et, d'autre part, d'un échantillonneur-bloqueur en série avec ce circuit et qui échantillonne, à chaque retour de balayage vertical, la tension aux bornes du condensateur et maintient cette tension à la valeur échantillonnée pendant la période d'aller de ce balayage vertical.

Avec un échantillonneur-bloqueur il n'est pas injecté de tension parabolique dans le circuit de commande du courant dans le déviateur et il n'est, ainsi, pas nécessaire de prévoir de correction de linéarité.

4

On a, certes, déjà proposé d'utiliser un tel échantillonneur-bloqueur dans un dispositif de balayage vertical du type dans lequel les signaux sensiblement en dents de scie engendrés par un oscillateur sont amplifiés et alimentent directement le déviateur vertical en série avec un condensateur de liaison et une résistance de mesure. Mais dans ce dispositif connu le signal de tension aux bornes du condensateur de liaison est transmis directement à l'entrée de l'échantillonneur-bloqueur. Or on a constaté que si l'on utilisait de cette manière un échantillonneur-bloqueur dans un circuit de balayage vertical en commutation (c'est-à-dire du type du brevet susmentionné il serait malgré tout nécessaire de conférer une faible valeur au gain en boucle ouverte de l'asservissement statique ce qui réduirait pratiquement à néant l'avantage tiré de l'utilisation d'un tel échantillonneur-bloqueur.

On utilise donc, selon l'invention, un circuit correcteur, notamment à retard de phase, pour augmenter le gain en boucle ouverte et donc la qualité de la régulation.

Dans une réalisation particulièrement simple et économique le circuit correcteur à retard de phase est constitué par deux résistances et un condensateur.

L'échantillonneur-bloqueur peut faire partie d'un circuit intégré.

D'autres caractéristiques et avantages de l'invention apparaîtront avec la description de l'un de ses modes de réalisation, celle-ci étant effectuée en se référant aux dessins ci-annexés sur lesquels :

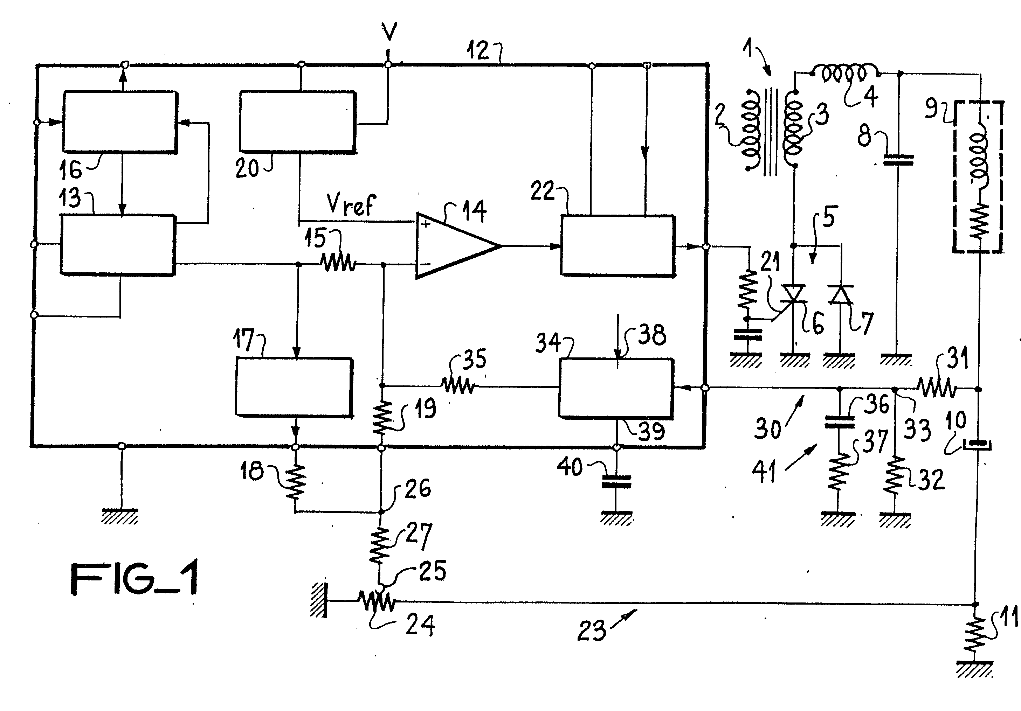

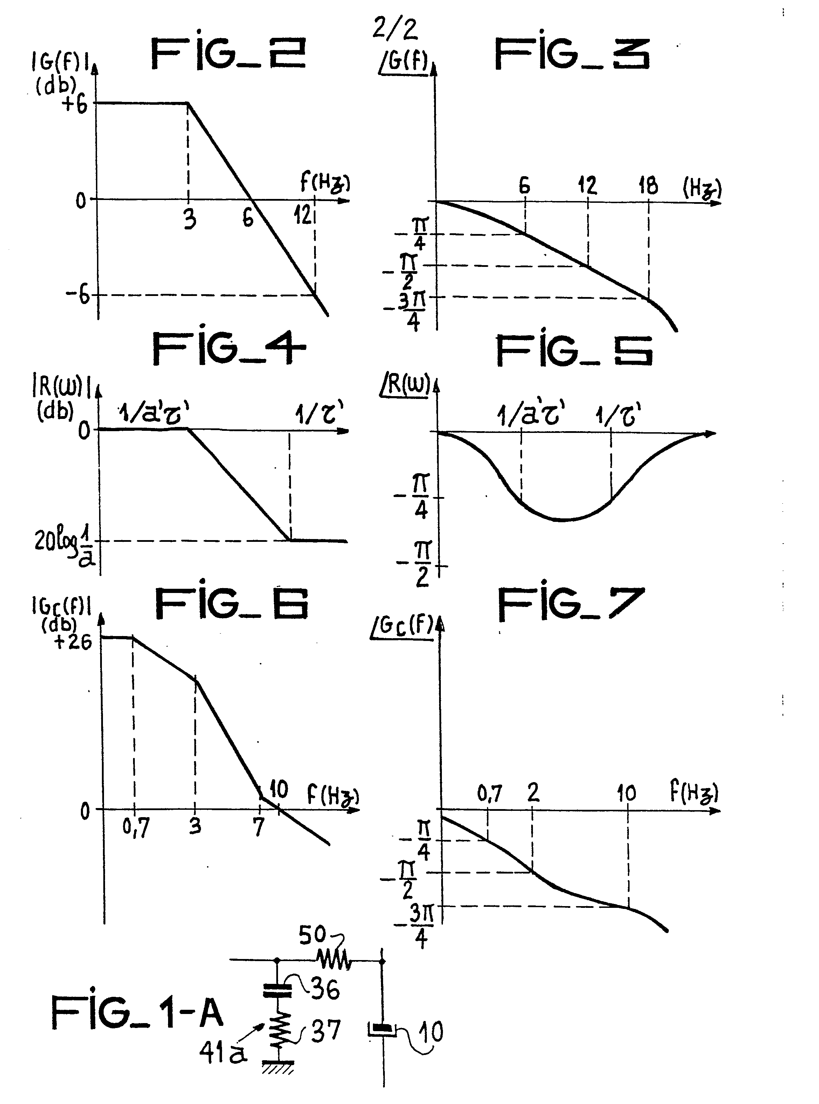

- la figure 1 est un schéma d'un dispositif de balayage vertical selon l'invention,

- la figure 1$_A$ représente une partie d'un dispositif de balayage pour une variante,

- la figure 2 représente la variation, en fonction de la fréquence, du gain de la fonction de transfert en boucle ouverte de la boucle statique lorsque celle-ci ne comporte pas de circuit correcteur,

- la figure 3 est un diagramme montrant les variations de la phase en fonction de la fréquence dans les mêmes conditions que celles de la figure 2,

- la figure 4 est un diagramme illustrant les variations, en fonction de la fréquence, du gain de la fonction de transfert d'un circuit correcteur à retard de phase,

- la figure 5 montre les variations de la phase de la fonction de transfert de ce même circuit correcteur en fonction de la fréquence, et,

- les figures 6 et 7 correspondent respectivement aux figures 2 et 3 mais pour une boucle d'asservissement statique comportant un circuit correcteur à retard de phase.

Le dispositif de balayage vertical représenté sur la figure 1 comporte un transformateur-ligne 1 recevant sur son enroulement primaire 2 des impulsions de retour ligne et dont l'enroulement secondaire 3 est connecté, d'un côté, à une inductance 4 et, de l'autre côté, à un interrupteur électronique 5 constitué par un thyristor 6, dont la cathode est à la masse, et par une diode 7 dont l'anode est à la masse et qui est donc en parallèle, mais en sens inverse, avec le thyristor. La borne de l'inductance 4 opposée au secondaire 3 est reliée à la masse par l'intermédiaire d'un condensateur de filtrage 8. C'est en parallèle sur ce condensateur 8 qu'est disposé l'ensemble en série du déviateur vertical 9, du condensateur de liaison 10 et de la résistance de mesure 11. La capacité du condensateur 10 est suffisamment élevée pour que la tension aux bornes dudit ensemble en série garde un signe constant. L'interrupteur 5 peut ainsi être unidirectionnel en tension mais bidirectionnel en courant.

L'énergie disponible aux bornes du condensateur 8, et donc l'intensité du courant traversant le déviateur vertical 9, dépendent, à chaque balayage de ligne, du temps de conduction du thyristor 6. Ce thyristor est donc commandé pour qu'à chaque ligne il soit conducteur pendant un temps qui dépend du numéro de cette ligne.

6

Cette commande du thyristor est assurée par un circuit intégré 12 qui comprend un oscillateur 13 délivrant des signaux en dents de scie à la fréquence de balayage vertical à l'entrée inverseuse (-) d'un amplificateur différentiel 14, faisant également partie du circuit 12, par l'intermédiaire d'une résistance 15. Cet oscillateur est associé à un circuit de déclenchement 16 interne au circuit 12 permettant de synchroniser les signaux en dents de scie aux signaux vidéo reçus par exemple d'une antenne.

La sortie de l'oscillateur 13 est également connectée à l'entrée d'un circuit de correction en S 17 - faisant partie du circuit 12 -dont la sortie est reliée à l'entrée inverseuse de l'amplificateur 14 par l'intermédiaire d'une résistance 18 externe au circuit intégré 12 - c'est-à-dire sous forme discrète -, et d'une résistance intégrée 19.

Sur l'entrée non inverseuse (+) de l'amplificateur 14 est appliquée une tension de valeur $V_{ref}$ constante grâce à un générateur de tension de référence 20 faisant partie du circuit intégré 12.

La sortie de l'amplificateur 14 est reliée à la gâchette 21 du thyristor 6 par l'intermédiaire d'un convertisseur tension - temps, ou tension - angle d'amorçage, 22, qui fait également partie du circuit intégré 12.

Pour asservir l'intensité du courant traversant le déviateur vertical 9 au signal de consigne fourni par l'oscillateur 13 et le circuit 17, on prévoit une boucle d'asservissement dynamique 23. Dans cette boucle le signal de mesure est la tension aux bornes de la résistance 11. En parallèle sur cette résistance est disposée la résistance totale d'un potentiomètre 24 dont le curseur, ou prise, 25, est relié au point de jonction 26 entre les résistances 18 et 19 par l'intermédiaire d'une résistance 27 ne faisant pas partie,comme le potentiomètre 24, du circuit 12.

L'asservissement statique, c'est-à-dire la régulation de la tension moyenne aux bornes du condensateur 10, est obtenu à l'aide d'une boucle d'asservissement statique 30. A cet effet une résistance 31 est reliée d'un côté à l'armature du condensateur 10 connectée au déviateur 9, et, de l'autre côté, à la masse par l'intermédiaire d'une résistance 32. Le point commun 33 aux résistances 31 et 32 est relié à l'entrée d'un échantillonneur-bloqueur 34 faisant partie du circuit intégré 12 dont la sortie est reliée à l'entrée inverseuse de l'amplificateur 14 par l'intermédiaire d'une résistance intégrée 35.

En parallèle sur la résistance 32 est disposé l'ensemble en série d'un condensateur 36 et d'une résistance 37 dont une borne est à la masse.

Une entrée 38 de l'échantillonneur-bloqueur 34 reçoit des impulsions de retour trame tandis qu'une borne 39 de cet échantillonneur est reliée à l'armature d'un condensateur 40 externe au circuit intégré 12 et dont l'autre armature est à la masse. Ce condensateur 40 est destiné à mémoriser la tension échantillonnée.

L'échantillonneur-bloqueur mémorise pendant la période de retour de balayage vertical une tension représentant la tension aux bornes de l'ensemble en série du condensateur 10 et de la résistance 11 c'est-à-dire - la tension aux bornes de la résistance 11 étant faible par rapport à la tension aux bornes du condensateur 10 - pratiquement la tension aux bornes du dit condensateur 10. Le signal de mesure de l'asservissement statique est ainsi une tension constante. Il n'est donc pas nécessaire d'apporter une correction de linéarité à la tension de consigne fournie par l'oscillateur 13 et le circuit 17.

Cependant, comme on l'a mentionné ci-dessus, s'il n'était pas prévu de circuit correcteur à retard de phase à résistances 31, 32 et 37 et condensateur 36 il serait nécessaire de conférer une faible valeur au gain en boucle ouverte de la régulation statique pour que cette régulation soit stable ; la régulation serait ainsi de mauvaise qualité comme on peut le constater à l'examen des diagrammes des figures 2 et 3. Sur la figure 2 on a porté la fréquence (en hertz) en abscisses et le gain G(A) (en décibels) de la fonction de transfert en boucle ouverte en ordonnées. Sur la figure 3 G (f) en ordonnées est la phase de cette fonction de transfert.

L'utilisation d'un circuit, ou réseau, 41 correcteur à retard de phase permet, à fréquence égale, d'augmenter dans des proportions importantes le gain de la boucle d'asservissement statique sans diminuer les marges de gain et de phase de cette boucle qu'il est nécessaire de conserver pour tenir compte des dispersions, inévitables, sur les valeurs des caractéristiques des composants de cette boucle. Ces caractéristiques de la boucle apparaissent sur les figures 6 et 7 qui correspondent au cas où le rapport entre la valeur de la résistance équivalente aux résistances 31 et 32 en parallèle et la valeur de la résistance 37 est égal à 10 et la constante de temps ' de l'ensemble en série de la résistance 37 et du condensateur 36, c'est-à-dire le produit de la valeur de cette résistance par la capacité du condensateur, est égale à 22 millisecondes.

L'utilisation du circuit 41 permet de diminuer l'erreur statique, c'est-à-dire l'écart du signal de mesure par rapport au signal de consigne en régime permanent, et cela sans diminuer la stabilité de la boucle. L'homme de métier saura choisir les valeurs des résistances 31, 32 et 37 ainsi que la capacité du condensateur 36 en fonction de son utilisation.

Pour ce choix il tiendra compte plus particulièrement du compromis qu'il est nécessaire de trouver entre, d'une part, la qualité de l'erreur statique, c'est-à-dire la tolérance sur la tension aux bornes du condensateur de liaison 10, et, d'autre part, la qualité de la réponse transitoire qui intervient notamment lorsque l'utilisateur commande un changement de programme reçu sur son écran de télévision.

Les résistances 31 et 32 constituent un pont diviseur permettant de réduire la tension appliquée à l'entrée du circuit intégré 12. Ainsi ces résistances 31 et 32 font partie à la fois du pont diviseur et du réseau 41. Le nombre de composants en est ainsi diminué.

S'il n'est pas nécessaire de diviser la tension aux bornes du condensateur 10 on peut (figure 1$_A$) se passer de la résistance 32. Dans ce cas, pour que le fonctionnement soit le même au point de vue fréquentiel, il est nécessaire, comme le montre le calcul ci-dessous, de conférer à la résistance 50 la valeur de la résistance équivalente aux résistances 31 et 32 en parallèle.

9

La fonction de transfert du réseau 41a (fig. $1_A$) à la valeur suivante :

$$\frac{V_s}{V_e} = \frac{1 + \tau p}{1 + a \tau p} \; ;$$

dans cette formule $V_s$ est la tension aux bornes de l'ensemble en série du condensateur 36 et de la résistance 37, $V_e$ la tension aux bornes du condensateur 10 et de la résistance 11 en série, et :

$$\tau = R_2 C,$$

$$a = 1 + \frac{R_1}{R_2},$$

$$p = j\omega = j 2 \Pi f,$$

$R_1$, étant la valeur de la résistance 50, $R_2$ la valeur de la résistance 37 et C la capacité du condensateur 36.

La fonction de transfert du réseau 41 (fig. 1) est la suivante :

$$\frac{V_s}{V_e} = \frac{R_5}{R_5 + R_4} \quad X \quad \frac{1 + R_6 Cp}{1 + R_6 + \dfrac{R_4 R_5}{R_4 + R_5} Cp}$$

$$= \frac{R_5}{R_5 + R_4} \quad \frac{1 + \tau' p}{1 + a\tau' p},$$

avec $\tau' = R_6 C$ et $a' = 1 + \dfrac{\dfrac{R_4 R_5}{R_4 + R_5}}{R_6}$ $\quad R_4, R_5$

et $R_6$ étant les valeurs des résistances respectivement 31, 32 et 37.

On voit ainsi qu'au gain statique, $\dfrac{R_5}{R_4 + R_5}$, près les fonctions de transfert des réseaux 41 et 41a sont les mêmes si la valeur

10

$R_1$ de la résistance 50 est égale à la valeur $\dfrac{R_4 \; R_5}{R_4 + R_5}$ des résistances 31 et 32 en parallèle.

Les figures 4 et 5 montrent les caractéristiques du réseau 41.

La disposition du condensateur 36 et de la résistance 37 entre la jonction 33 des résistances 31 et 32 et la masse permet de n'utiliser qu'une seule entrée pour le circuit intégré 12.

Enfin aucun autre amplificateur n'étant prévu entre l'oscillateur 13 et l'amplificateur différentiel 14 il n'est pas nécessaire de prévoir un condensateur de filtrage de la composante continue entre cet oscillateur et cet amplificateur.

11

## REVENDICATIONS

1. Dispositif de balayage vertical pour récepteur de télévision dans lequel l'énergie nécessaire pour engendrer le courant traversant le déviateur vertical (9) est tirée des impulsions de retour ligne grâce à un moyen de filtrage (4, 8) en série avec un interrupteur commandé (5,6,7) qui, à chaque ligne, est conducteur pendant un temps qui est fonction du numéro de cette ligne, le déviateur vertical (9) étant en série avec un condensateur de liaison (10) dont la tension moyenne à ses bornes est maintenue sensiblement constante grâce à une boucle (30) de régulation statique, caractérisé en ce que la tension aux bornes du condensateur de liaison (10) est introduite dans la boucle statique par l'intermédiaire d'un échantillonneur-bloqueur (34, 40) qui, à chaque période de retour de balayage vertical, emmagasine un signal représentant cette tension et maintient celle-ci pratiquement constante pendant la période de balayage vertical et qui est précédé par un réseau correcteur (41, 41a) permettant d'augmenter le gain en boucle ouverte de la boucle statique.

2. Dispositif selon la revendication 1, caractérisé en ce que le réseau correcteur (41, 41a) est du type à retard de phase.

3. Dispositif selon la revendication 2, caractérisé en ce que le réseau (41) correcteur à retard de phase comprend un condensateur (36) en série avec une résistance (37).

4. Dispositif selon la revendication 3, caractérisé en ce que le réseau comprend un pont diviseur à deux résistances (31, 32) en parallèle sur le condensateur de liaison (10), et en ce que la résistance (37) et le condensateur (36) de ce réseau correcteur (41) sont en parallèle sur une des résistances (32) de ce pont.

5. Dispositif selon l'une quelconque des revendications précédentes, caractérisé en ce que l'échantillonneur (34) fait partie d'un circuit intégré (12) comprenant d'autres éléments de commande de la conduction de l'interrupteur (5, 6, 7).

12

6. Dispositif selon la revendication 5, caractérisé en ce que le circuit intégré (12) comporte également un générateur (13, 17) de signaux de consigne sensiblement en dents de scie à la fréquence de balayage vertical connecté à l'entrée d'un amplificateur (14) recevant également le signal de sortie de l'échantillonneur-bloqueur (34, 40) ainsi qu'un convertisseur (22) tension - temps dont l'entrée est reliée à la sortie de l'amplificateur et·dont la sortie est destinée à fournir les signaux de commande à l'électrode (21) de commande de l'interrupteur (5, 6, 7).

7. Dispositif selon l'une quelconque des revendications précédentes, caractérisé en ce qu'une résistance de mesure (11) est en série avec le déviateur vertical (9) et le condensateur de liaison (10), le signal de tension aux bornes de cette résistance, qui représente l'intensité du courant traversant le déviateur, étant le signal de mesure d'une boucle (23) d'asservissement dynamique de l'intensité du courant à une consigne.

8. Dispositif selon la revendication 7, caractérisé en ce que la capacité du condensateur de balayage (10) est suffisamment élevée pour que la tension aux bornes de l'ensemble en série du déviateur vertical (9), de ce condensateur et de la résistance de mesure (11) garde un signe constant, l'interrupteur (5, 6, 7) en série avec les moyens de filtrage (4,8) étant ainsi unidirectionnel en tension et bidirectionnel en courant.

9. Récepteur de télévision caractérisé en ce qu'il comporte un dispositif de balayage vertical selon l'une quelconque des revendications précédentes.

FIG_1

$V_{ref}$

1/2

0056921

FIG_2

FIG_3

FIG_4

FIG_5

FIG_6

FIG_7

FIG_1-A